# EUROPÄISCHE PATENTANMELDUNG

(11) **EP 2 645 116 A1**
(43) Veröffentlichungstag der Anmeldung: **02.10.2013**
(21) Anmeldenummer: 12162464.7
(22) Anmeldetag: 30.03.2012
(51) Int. Cl.: G01R 31/36

(54) **Anordnung zum Messen der elektrischen Spannung einzelner Zellen in einem Batteriesystem**

(71) Anmelder: Magna E-Car Systems GmbH & Co OG, 8041 Graz (AT)
(72) Erfinder: Erhart, Michael, 8075 Hart bei Graz (AT)
(74) Vertreter: Rausch, Gabriele

(57) **Zusammenfassung**

Eine Anordnung zum Messen der elektrischen Spannung von zumindest zwei Zellen in einem Batteriesystem, welches mindestens zwei Batteriemodule aufweist die elektrisch über einen Modulverbinder verbunden sind, wobei zumindest eine Elektronikeinheit vorgesehen ist, die dazu vorbereitet ist die elektrische Spannung von zumindest zwei Zellen über Messleitungen zu erfassen, wobei eine erste Zelle in einem ersten Batteriemodul angeordnet ist und zumindest eine zweite Zelle in einem vom ersten Batteriemodul verschiedenen zweiten Batteriemodul angeordnet ist.

## Beschreibung

Die vorliegende Erfindung betrifft eine Anordnung zum Messen der elektrischen Spannung von zumindest zwei Zellen in einem Batteriesystem, insbesondere in einem Traktionsbatteriesystem für ein Fahrzeug.

An Batteriesysteme werden immer höhere Anforderungen an Betriebssicherheit und Zuverlässigkeit gestellt, da ein Ausfall des Batteriesystems häufig zu einem Ausfall des Gesamtsystems führt. Darüber hinaus kann ein Ausfall eines Batteriesystems auch zu einer Personengefährdung führen, beispielsweise durch das Entweichen von Gas aus einzelnen Zellen, oder durch einen Brand des Batteriesystems. Weiters soll ein Batteriesystem eine möglichst lange Lebensdauer aufweisen, sowie einen über diese Lebensdauer nur geringen Verlust an nutzbarem Energieinhalt.

Übersteigt die vom Batteriesystem geforderte elektrische Spannung die Spannung einer einzelnen Zelle, so müssen mehrere Zellen elektrisch miteinander verbunden werden. Um den Anforderungen zu genügen werden die einzelnen Zellen dabei in Serie, und teilweise zusätzlich parallel geschaltet.

Insbesondere bei Batteriesystemen mit Lithium-Ionen-Zellen ist eine Überwachung der einzelnen Zellen hinsichtlich ihrer Spannung erforderlich, da produktionsbedingte Unterschiede der Zellen zu unterschiedlichen Ladezuständen derselben führen. Bei einer Ladung des Batteriesystems mit einer konstanten Ladungsspannung würden einzelne Zellen stärker oder weniger stark geladen werden. Besonders eine überhöhte Ladung oder die Belastung mit einer zu hohen Spannung ist für Zellen dieses Typs schädlich und kann in weiterer Folge die Lebensdauer des Batteriesystems deutlich reduzieren. Um derartigen Effekten vorzubeugen können die Ladungszustände der einzelnen Zellen aneinander angeglichen werden. Dabei wird elektrische Energie von Zellen mit überhöhter Ladung zu Zellen mit geringerer Ladung transferiert. Alternativ dazu wird überschüssige Ladung von Zellen mit überhöhter Ladung durch Entladewiderstände abgebaut, sodass alle Zellen einen annähernd einheitlichen Ladezustand aufweisen. Um dies zu bewerkstelligen ist Kenntnis über die Spannung der einzelnen Zellen erforderlich.

Batteriesysteme weisen daher in der Regel eine oder mehrere Elektronikeinheiten auf, welche die einzelnen Zellen überwachen, und als eine Eingangsgröße für diese Überwachung die elektrische Spannung der einzelnen Zellen nutzen. Die Spannungsermittlung der einzelnen Zellen erfolgt dabei durch differentielle Spannungsmessung an zwei Messpunkten.

Insbesondere beim Einsatz in Fahrzeugen müssen die geometrischen Abmessungen des Batteriesystems an die Bauraumverhältnisse des Fahrzeugs angepasst werden. Dies führt dazu, dass die einzelnen Zellen zwar elektrisch seriell miteinander verbunden sein sollen, aber räumlich nicht unmittelbar aneinander angeordnet sein können. Um diesem Umstand Rechnung zu tragen werden die Zellen des Batteriesystems üblicherweise auf mehrere Batteriemodule aufgeteilt. Jedes Batteriemodul besteht dabei aus Zellen die elektrisch miteinander verbunden und unmittelbar aneinander angeordnet sind. Die einzelnen Batteriemodule können im Batteriesystem räumlich frei angeordnet werden, beispielsweise nebeneinander oder übereinander. Elektrisch ist jeweils ein Batteriemodul mit dem nächsten Batteriemodul über einen Modulverbinder verbunden.

Ein Batteriesystem der gattungsgemäßen Art ist aus der Offenlegung WO 2010/134625 A1 bekannt. Bei diesem Batteriesystem sind die Zellen auf drei Batteriemodule aufgeteilt. Die Spannung jeder Zelle wird durch differentielle Spannungsmessung ermittelt, wobei die einzelnen gemessenen Spannungssignale über Messleitungen an integrierte Schaltungen übermittelt werden. Dabei ist jedem Batteriemodul eine integrierte Schaltung zugeordnet.

Bei den genannten Anwendungen ist es erwünscht möglichst wenige integrierte Schaltungen vorzusehen, um die Gesamtkosten des Batteriesystems gering zu halten. Bei der Entwicklung dieser integrierten Schaltungen ist daher die Anzahl der Zellen je Batteriesystem sowie die Aufteilung dieser Zellen auf einzelne Batteriemodule zu berücksichtigen, da ja die Anzahl der je integrierten Schaltung erforderlichen Spannungssignal-Eingänge davon abhängt.

Da die Aufgabe der integrierten Schaltung, nämlich die Erfassung von Spannungssignalen und deren Weiterverarbeitung, stets die gleiche bleibt, kann die gleiche integrierte Schaltung für verschiedene Batteriesysteme eingesetzt werden. Die integrierte Schaltung muss folglich nur einmal entwickelt und erprobt werden, wodurch die Kosten bei allen Batteriesystemen sinken in denen die integrierte Schaltung zum Einsatz kommt.

Erhöht sich die Anzahl der Zellen je Batteriemodul beispielsweise von 36 auf 40, und die integrierte Schaltung ist zum Erfassen der elektrischen Spannung von 12 Zellen vorbereitet, so ist für jedes Batteriemodul eine zusätzliche integrierte Schaltung erforderlich. Die Anzahl der zusätzlich erforderlichen integrierten Schaltungen multipliziert sich dabei mit der Anzahl an Batteriemodulen des Batteriesystems. Die Kosten des Batteriesystems steigen entsprechend.

Es ist eine Aufgabe der Erfindung, Batteriesysteme der genannten Art in dieser Hinsicht zu verbessern und insbesondere eine Anordnung zum Messen der elektrischen Spannung von Zellen anzugeben, die bei veränderlicher Zell-Anzahl je Batteriemodul möglichst wenige integrierte Schaltungen erfordert.

Die Lösung der Aufgabe erfolgt durch eine Anordnung zum Messen der elektrischen Spannung von zumindest zwei Zellen in einem Batteriesystem mit den Merkmalen des Anspruchs 1.

Erfindungsgemäß wird eine Anordnung zum Messen der elektrischen Spannung von zumindest zwei Zellen in einem Batteriesystem vorgeschlagen, welches mindestens zwei Batteriemodule aufweist die elektrisch über einen Modulverbinder verbunden sind, wobei zumindest eine erste Elektronikeinheit vorgesehen ist, die dazu vorbereitet ist die elektrische Spannung einzelner Zellen über Messleitungen zu erfassen, wobei eine erste Zelle in einem ersten Batteriemodul angeordnet ist und zumindest eine zweite Zelle in einem vom ersten Batteriemodul verschiedenen zweiten Batteriemodul angeordnet ist.

Weiterbildungen der Erfindung sind in den abhängigen Ansprüchen, der Beschreibung sowie den beigefügten Zeichnungen angegeben.

Vorzugsweise erfolgt die Messung der elektrischen Spannung von zumindest zwei Zellen durch differentielle Spannungsmessung an Polen der Zellen und/oder an geeigneten Stellen an elektrischen Leitern zwischen benachbarten Zellen. Dadurch dass die elektrischen Leiter durch geeignete Verbindungstechnik niederohmig mit Polen benachbarter Zellen verbunden sind, kann durch Spannungsmessung am elektrischen Leiter auf die elektrische Spannung der Zellen rückgeschlossen werden.

Sind die Zellen nicht Bestandteil des selben Batteriemoduls, so wird die erste oder letzte Zelle eines Batteriemoduls mit der ersten oder letzten Zelle eines zweiten Batteriemoduls über einen Modulverbinder elektrisch verbunden. Um die Montage und Wartung des Batteriesystems zu vereinfachen kann der Modulverbinder lösbare Verbindungselemente enthalten, beispielweise eine oder mehrere Steckverbindungen. Auch andere lösbare elektrische Verbindungstechniken sind an dieser Stelle realisierbar, beispielweise Schraubverbindungen mit Polschuhen.

Gemäß einer Ausgestaltung der Erfindung ist die elektrische Spannung einer ersten oder letzten Zelle eines ersten Batteriemoduls anhand der Spannungsdifferenz zwischen einer ersten Messleitung und einer zweiten Messleitung ermittelbar, und die elektrische Spannung einer ersten oder letzten Zelle eines zweiten Batteriemoduls anhand der Spannungsdifferenz zwischen einer dritten Messleitung und einer vierten Messleitung ermittelbar. Die Ermittlung des elektrischen Spannungsabfalls am Modulverbinder ist mit einer derartigen Anordnung zwar möglich, aber nicht erforderlich, da dieser in keine Messung eingeht. Dies vereinfacht in weiterer Folge die Weiterverarbeitung der Signale in der ersten Elektronikeinheit, da auf diese Weise Spannungs-Signale ähnlicher Größenordnung in der ersten Elektronikeinheit verarbeitet werden.

Besonders vorteilhaft ist es, wenn die erste bis vierte Messleitung zu einer gemeinsamen Elektronikeinheit führen. Alternativ dazu sind auch andere Anordnungen denkbar, in denen die Messleitungen auf verschiedene Elektronikeinheiten aufgeteilt werden. Die Zuordnung dieser Messleitungen zu einer gemeinsam Elektronikeinheit erhöht jedoch die Übersichtlichkeit der Architektur.

Die erfindungsgemäße Anordnung ist besonders bei Batteriesystemen von Vorteil, in denen Lithium-Ionen Zellen zum Einsatz kommen. Bei dieser Zelltechnologie ist die Kenntnis über die elektrische Spannung der Zellen besonders relevant, da eine inkorrekte Belastung einzelner Zellen, beispielsweise in einer Serienschaltung, die zu erwartende Lebensdauer der Zellen deutlich herabsetzen kann. Die Erfindung kann darüber hinaus aber auch bei Batteriesystemen mit anderen Zelltechnologien angewendet werden, beispielsweise bei Batteriesystemen mit Lithium-Luft-Zellen.

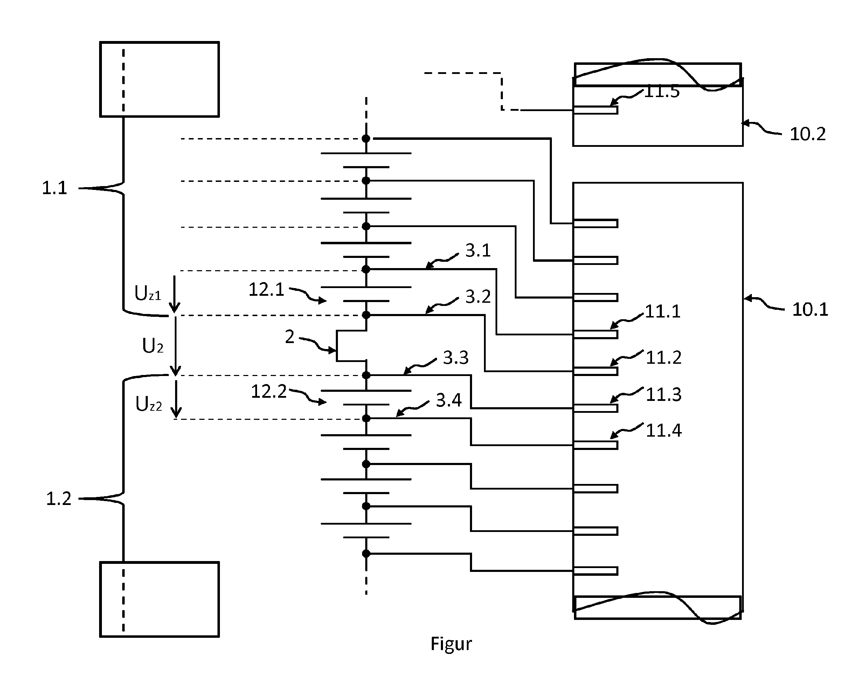

Die Erfindung wird im Folgenden beispielhaft unter Bezugnahme auf die Figur beschrieben.

In der Figur ist eine erfindungsgemäße Anordnung dargestellt, welche eine bevorzugte Ausführungsform der Erfindung beschreibt. Darin ist ein Ausschnitt eines Batteriesystems dargestellt, in dem mehrere Zellen, darunter 12.1 und 12.2, auf ein erstes Batteriemodule 1.1 und ein zweites Batteriemodul 1.2 aufgeteilt sind. Das erste Batteriemodul 1.1 und das zweite Batteriemodul 1.2 sind elektrisch durch einen Modulverbinder 2 miteinander verbunden.

Die elektrische Spannung U_{Z1} einer ersten Zelle 12.1, die dem ersten Batteriemodul 1.1 zugeordnet ist und sich entweder an erster oder an letzter Stelle der Zellen im Batteriemodul befindet, wird durch eine erste Messleitung 3.1 und eine zweite Messleitung 3.2 an geeigneter Stelle abgegriffen. In selber Weise wird die elektrische Spannung U_{Z2} einer zweiten Zelle 12.2, die dem zweiten Batteriemodul 1.2 zugeordnet ist und sich entweder an erster oder an letzter Stelle der Zellen im Batteriemodul befindet, durch eine dritte Messleitung 3.4 und eine vierte Messleitung 3.4 an geeigneter Stelle abgegriffen. Die zum Abgriff der elektrischen Spannung geeigneten Stellen sind beispielsweise Pole der Zellen, oder elektrische Leiter zwischen benachbarten Zellen. Die elektrische Spannung der anderen Zellen des ersten Batteriemoduls 1.1 und des zweiten Batteriemoduls 1.2 wird in gleicher Weise mittels Messleitungen abgegriffen, zur besseren Übersichtlichkeit ist dies in der Figur jedoch nicht dargestellt.

Die durch die Messleitungen abgegriffenen elektrischen Spannungen werden in Elektronikeinheiten 10.1, 10.2 erfasst und weiterverarbeitet. Dazu sind an jeder Elektronikeinheit 10.1, 10.2 Messleitungs-Eingänge vorgesehen, an denen die Messleitungen anschließbar sind. Die erste Messleitung 3.1 ist dabei an einem ersten Messleitungs-Eingang 11.1 einer ersten Elektronikeinheit 10.1 anschließbar, die zweite Messleitung 3.2 an einem zweiten Messleitungs-Eingang 11.2 der ersten Elektronikeinheit 10.1. Durch Erfassung und Weiterverarbeitung des Signals an der ersten Messleitung 3.1 und des Signals an der zweiten Messleitung 3.2 ist die elektrische Spannung U_{Z1} der ersten Zelle 12.1 ermittelbar. In gleicher Weise ist die dritte Messleitung 3.3 an einen dritten Messleitungs-Eingang 11.3 der ersten Elektronikeinheit 10.1 anschließbar, die vierte Messleitung 3.4 mit einem vierten Messleitungs-Eingang 11.4 der ersten Elektronikeinheit 10.1. Entsprechend wird das Signal an der dritten Messleitung 3.3 und an der vierten Messleitung 3.4 in der ersten Elektronikeinheit 10.1 erfasst und weiterverarbeitet, sodass die elektrische Spannung U_{Z2} der zweiten Zelle 12.2 erfassbar ist.

Zusätzlich zur ersten Elektronikeinheit 10.1 ist in der Figur auch eine zweite Elektronikeinheit 10.2 dargestellt, die zumindest einen fünften Messleitungs-Eingang 11.5 aufweist. Darüber hinaus können im Batteriesystem auch weitere Elektronikeinheiten vorgesehen sein, oder aber das Batteriesystem kommt mit der ersten Elektronikeinheit 10.1 aus.

Durch Erfassung und Auswertung der zweiten Messleitung 3.2 und der dritten Messleitung 3.3 in der ersten Elektronikeinheit 10.1 ist der elektrische Spannungsabfall U₂ am Modulverbinder 2 theoretisch erfassbar. Für den Betrieb des Batteriesystems ist die Kenntnis über den elektrische Spannungsabfall U₂ am Modulverbinder 2 allerdings nicht erforderlich, sondern lediglich die Kenntnis über die elektrische Spannung der Zellen. Durch die erfindungsgemäße Anordnung der Messleitungen wird jedoch sichergestellt, dass der elektrische Spannungsabfall U₂ am Modulverbinder 2 nicht in die Erfassung der elektrischen Spannung U_{Z1}, U_{Z2} der Zellen 12.1 und 12.2 durch die erste Elektronikeinheit 10.1 eingeht.

### Bezugszeichenliste

- 1.1: Erstes Batteriemodul
- 1.2: Zweites Batteriemodul
- 2: Modulverbinder
- 3.1: Erste Messleitung
- 3.2: Zweite Messleitung
- 3.3: Dritte Messleitung
- 3.4: Vierte Messleitung

- 10.1: Erste Elektronikeinheit
- 10.2: Zweite Elektronikeinheit
- 11.1: Erster Messleitungs-Eingang
- 11.2: Zweiter Messleitungs-Eingang
- 11.3: Dritter Messleitungs-Eingang
- 11.4: Vierter Messleitungs-Eingang
- 11.5: Fünfter Messleitungs-Eingang
- 12.1: Erste Zelle
- 12.2: Zweite Zelle

- U_{Z1}: Elektrische Spannung einer ersten Zelle
- U_{Z2}: Elektrische Spannung einer zweiten Zelle
- U₂: Elektrischer Spannungsabfall am Modulverbinder

## Patentansprüche

1. Anordnung zum Messen der elektrischen Spannung (U_{Z1}, U_{Z2}) von zumindest zwei Zellen (12.1, 12.2) in einem Batteriesystem, welches mindestens zwei Batteriemodule (1.1, 1.2) aufweist die elektrisch über einen Modulverbinder (2) verbunden sind, wobei zumindest eine erste Elektronikeinheit (10.1) vorgesehen ist, die dazu vorbereitet ist die elektrische Spannung (U_{Z1}, U_{Z2}) der Zellen (12.1, 12.2) über Messleitungen (3.1, 3.2, 3.3, 3.4) zu erfassen,
**dadurch gekennzeichnet, dass** zumindest eine erste Zelle (12.1) in einem ersten Batteriemodul (1.1) angeordnet ist und zumindest eine zweite Zelle (12.2) in einem vom ersten Batteriemodul (1.1) verschiedenen zweiten Batteriemodul (1.2) angeordnet ist.

2. Anordnung zum Messen der elektrischen Spannung (U_{Z1}, U_{Z2}) von zumindest zwei Zellen (12.1, 12.2) in einem Batteriesystem nach Anspruch 1,
**dadurch gekennzeichnet, dass** die elektrische Spannung (U_{Z1}, U_{Z2}) der Zellen (12.1, 12.2) durch differentielle Spannungsmessung an Polen der Zellen, und/oder an geeigneten Stellen an elektrischen Leitern zwischen benachbarten Zellen erfassbar ist.

3. Anordnung zum Messen der elektrischen Spannung (U_{Z1}, U_{Z2}) von zumindest zwei Zellen (12.1, 12.2) in einem Batteriesystem nach Anspruch2,
**dadurch gekennzeichnet , dass** die elektrische Spannung (U_{Z1}) einer ersten oder letzten Zelle (12.1) eines ersten Batteriemoduls (1.1) anhand der Spannungsdifferenz zwischen einer ersten Messleitung (3.1) und einer zweiten Messleitung (3.2) ermittelbar ist, und dass die elektrische Spannung (U_{Z2}) einer ersten oder letzten Zelle (12.2) des zweiten Batteriemoduls (1.2) anhand der Spannungsdifferenz zwischen einer dritten Messleitung (3.3) und einer vierten Messleitung (3.4) ermittelbar ist.

4. Anordnung zum Messen der elektrischen Spannung (U_{Z1}, U_{Z2}) von zumindest zwei Zellen (12.1, 12.2) in einem Batteriesystem nach Anspruch 3,
**dadurch gekennzeichnet, dass** die erste bis vierte Messleitung (3.1, 3.2, 3.3, 3.4) zur ersten Elektronikeinheit (10.1) führen.

5. Anordnung zum Messen der elektrischen Spannung (U_{Z1}, U_{Z2}) von zumindest zwei Zellen (12.1, 12.2) in einem Batteriesystem nach Anspruch 1,
**dadurch gekennzeichnet, dass** es sich bei den Zellen um Lithium-Ionen-Zellen handelt.
